(19) Europäisches Patentamt
European Patent Office
Office européen des brevets

(11) **EP 3 443 369 B1**

(12) **FASCICULE DE BREVET EUROPEEN**

(45) Date de publication et mention
de la délivrance du brevet:
**06.05.2020 Bulletin 2020/19**

(21) Numéro de dépôt: **17713981.3**

(22) Date de dépôt: **03.04.2017**

(51) Int Cl.:
*G01R 31/28* *(2006.01)*     *G01R 31/30* *(2006.01)*
*G01R 31/317* *(2006.01)*     *G06F 17/50* *(2006.01)*

(86) Numéro de dépôt international:
**PCT/EP2017/057801**

(87) Numéro de publication internationale:
**WO 2017/178258 (19.10.2017 Gazette 2017/42)**

(54) **SYSTEME ET PROCEDE DE TEST D'UN CIRCUIT INTEGRE**

SYSTEM UND VERFAHREN ZUM TESTEN EINER INTEGRIERTEN SCHALTUNG

SYSTEM AND METHOD FOR TESTING AN INTEGRATED CIRCUIT

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **12.04.2016 FR 1653214**

(43) Date de publication de la demande:
**20.02.2019 Bulletin 2019/08**

(73) Titulaire: **Commissariat à l'Énergie Atomique
et aux Énergies Alternatives
75015 Paris (FR)**

(72) Inventeurs:
• **HERON, Olivier
78730 ROCHEFORT-EN-YVELINES (FR)**
• **OUATTARA, Boukary
91170 VIRY-CHATILLON (FR)**

(74) Mandataire: **Hammes, Pierre
Marks & Clerk France
Immeuble Visium
22, avenue Aristide Briand
94117 Arcueil Cedex (FR)**

(56) Documents cités:
**US-A1- 2009 027 990     US-A1- 2012 245 879
US-A1- 2014 123 085     US-B1- 6 216 099**

• **KINNIMENT D J ET AL: "On-chip structures for
timing measurement and test",
MICROPROCESSORS AND MICROSYSTEMS,
IPC BUSINESS PRESS LTD. LONDON, GB, vol.
27, no. 9, 1 octobre 2003 (2003-10-01), pages
473-483, XP004453319, ISSN: 0141-9331, DOI:
10.1016/S0141-9331(03)00096-6**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

# Description

La présente invention concerne de manière générale les circuits intégrés, et en particulier un système et un procédé de test d'un circuit intégré.

La fabrication des composants électroniques nécessite des procédés extrêmement complexes. En outre, la fabrication de tels composants nécessite une infrastructure complexe et coûteuse, telle que des usines de type fonderie pour fabriquer les circuits intégrés de ces composants électroniques à partir de silicium et sur la base de masques.

La miniaturisation des transistors dans le procédé de fabrication des circuits intégrés a permis de réaliser des circuits intégrés plus rapides, moins énergivores et moins onéreux pour une même fonction. Toutefois, cette technique réduit la fiabilité des transistors et de fait, la fiabilité globale du circuit intégré.

La fiabilité des circuits intégrés peut varier en fonction de la technologie utilisée. Par exemple, la fonction réalisée par le circuit intégré avec une technologie de fabrication 28nm peut tomber en panne plus tôt pendant son utilisation qu'avec une technologie 40nm ou une autre technologie plus obsolète (65nm par exemple). Par ailleurs, la durée de vie des produits électroniques tend à diminuer avec les progrès de la miniaturisation. Cette tendance est un obstacle majeur pour les systèmes électroniques embarqués par exemple dans le domaine de l'industrie de l'automobile, de l'avionique ou encore de la défense. De tels systèmes embarqués ne peuvent pas bénéficier des avantages de la miniaturisation pour améliorer leur performance, ce qui peut limiter la compétitivité dans de tels domaines. En effet, le niveau de fiabilité des circuits intégrés sur des technologies fines (par ex 28nm) est en deçà des exigences imposées par les autorités de certification et les normes actuelles.

La diminution de la fiabilité des circuits intégrés est due à la combinaison de phénomènes physiques et de phénomènes chimiques qui se manifestent dans les transistors des circuits intégrés. De tels phénomènes entraînent une variation des paramètres électriques qui tend à réduire la vitesse de commutation de chaque transistor. Ce ralentissement se traduit par la propagation retardée des signaux d'information qui peut in fine résulter par une altération des bits d'information. Une telle altération peut provoquer une panne du circuit intégré : le circuit intégré ne réalise alors plus correctement la fonction souhaitée (par exemple dysfonctionnement de la fonction freinage d'un véhicule).

La manifestation de ces phénomènes physiques et chimiques dans les transistors dépend de plusieurs variables : la géométrie, les matériaux utilisés, le dessin du motif, la tension d'alimentation et la température de jonction du transistor, la séquence, et la fréquence d'alternance des bits (entre un bit de valeur 0 et un bit de valeur 1) qui traversent le transistor. La fiabilité globale du circuit intégré dépend également de la manière d'interconnecter les transistors.

Le problème de fiabilité des transistors est généralement adressé par le fabricant semi-conducteur du circuit intégré. Toutefois, le problème de fiabilité est maintenant une contrainte majeure dans la phase de conception des circuits intégrés. Dans les approches connues, le concepteur utilise des outils logiciels capables de fournir une indication préliminaire sur le niveau de fiabilité du circuit intégré, avant sa fabrication. Toutefois de tels outils nécessitent l'utilisation d'une base de données qui comprend des constantes technologiques. Ces constantes technologiques dépendent de la géométrie, des matériaux utilisés, du dessin du motif, de la tension d'alimentation et de la température du transistor. Elles sont indispensables pour obtenir une estimation précise du niveau de fiabilité.

Le contenu de ces bases de données est généralement obtenu de manière empirique par le fabricant avec l'aide de moyens de test internes. Une telle base de données n'est pas disponible chez tous les fabricants de semi-conducteurs. Par ailleurs, ces informations sont de nature confidentielle de sorte que leur accès est fortement limité (accès sous condition de licence, accès limité à des acteurs tiers qui sous-traitent la fabrication de leur CI uniquement, etc.).

En outre, la base de données n'est pas complète car sa construction requière un processus de caractérisation de chaque type de transistors très long. Généralement, le fabricant construit cette base pour quelques cas représentatifs. Toutefois, les concepteurs des circuits intégrés ont besoin de connaître l'impact d'un choix de conception - par exemple d'une IP processeur X plutôt qu'un processeur Y- sur les risques du circuit intégré en cours de développement, quelle que soit la technologie utilisée.

Outre l'influence des choix de conception, les risques sur le circuit intégré sont également influencés par le profil de mission envisagé par l'utilisateur final du CI. Le profil de mission représente les conditions de fonctionnement prévues du circuit intégré pendant son utilisation dans le système final. Un profil de mission est notamment caractérisé par les paramètres suivants : la durée de fonctionnement du circuit intégré sous tension, la tension d'alimentation du circuit intégré, la température interne du circuit intégré et la technologie de fabrication du circuit intégré.

Il n'existe pas à ce jour de solutions de conception externalisé des usines de fabrication permettant au concepteur d'analyser en interne et précisément l'impact d'une technologie sur la fiabilité globale de son circuit intégré d'application.

La demande de brevet US2012/0245879A1 décrit un banc de test programmable pour caractériser un processus de fabrication de circuit intégré, et notamment les propriétés électriques d'un transistor. Cette puce de test peut être utilisée avant la fabrication d'un circuit intégré par un ingénieur concepteur. Le banc de test inclut une tranche de matériau semi-conducteur (« die ») de test qui contient des dispositifs sous test (DUT) de type transistors et une électronique de test et de mesure embarquée. Ce circuit intégré de référence est conçu, fabriqué et vendu par le fournisseur du banc de test. Le banc de test peut être configuré par un utilisateur pour lancer la caractérisation et récupérer les résultats de mesure. Le stockage des résultats est réalisé sous la forme d'un fichier dans la machine. Cette solution permet de caractériser les variations et la fiabilité du processus de fabrication du circuit pour différents profils de mission. Cependant, cette solution nécessite une expertise en fiabilité pour configurer le banc de test, alors que les ingénieurs concepteurs ne disposent pas généralement d'une telle expertise. Par ailleurs, cette solution ne permet pas d'estimer directement l'impact d'un choix de conception du circuit intégré sur sa fiabilité. En effet, les sorties de mesure du banc de test ne peuvent pas être exploitées pour réaliser une telle estimation.

Il existe donc un besoin pour un système et un procédé de test d'un circuit intégré, en phase de conception.

On connait, par ailleurs, la solution décrite dans la demande de brevet américaine US 2009/027990.

L'invention propose un système et un procédé de test d'un circuit intégré qui permet l'estimation de la variation dans le temps, due au vieillissement, de certaines grandeurs physiques d'un circuit interne. Par exemple la grandeur physique estimée peut être un temps de propagation interne ou un courant consommé par le circuit.

L'effet du vieillissement est simulé en fonction d'un profil de mission donné par un ingénieur de conception et cela sans connaissance a priori de la physique du vieillissement et des paramètres technologiques liés au procédé de fabrication.

Le profil de mission représente les conditions de fonctionnement du circuit intégré pendant son utilisation. Un profil de mission est notamment défini par quatre paramètres : la durée de fonctionnement du circuit sous tension, la tension d'alimentation du circuit, la température interne du circuit et la technologie de fabrication du circuit.

L'invention permet d'estimer la variation dans le temps de grandeurs ou paramètres physiques d'un circuit intégré à partir de sa description sans nécessiter d'expertise particulière pour définir le protocole de caractérisation à appliquer au système de test.

L'invention se base sur un système de test sur support matériel comprenant d'une part un équipement de test et d'autre part un circuit intégré de caractérisation dédié aux tests. La spécification du circuit intégré de caractérisation est indépendante de celle du circuit intégré d'application à réaliser.

L'invention se base également sur un procédé de test qui utilise le système de test et en particulier le contenu du circuit intégré de caractérisation pour estimer la variation d'une grandeur physique caractéristique du circuit intégré d'application dès les premières étapes de la phase de conception.

L'invention a ainsi pour objet un système de test d'un circuit intégré d'application représenté par une description comprenant un ensemble de chemins reliant plusieurs cellules logiques, le système de test comprenant un circuit intégré de caractérisation comprenant au moins deux structures de test configurables, chacune comprenant une pluralité de cellules logiques activables et une pluralité de connecteurs pour activer et interconnecter les cellules logiques, et un ensemble de test comprenant :

- un dispositif de contrôle du circuit intégré de caractérisation configuré pour faire varier au moins un paramètre physique d'au moins une structure de test configurable pour accélérer son vieillissement de sorte à obtenir au moins une structure de test dégradée,
- une interface pour recevoir au moins une description d'un circuit intégré d'application et extraire au moins un chemin de la description,
- un dispositif de configuration du circuit intégré de caractérisation pour activer et interconnecter au moins un sous-ensemble des cellules logiques d'au moins une structure de test dégradée et d'au moins une structure de test non dégradée, pour qu'elles réalisent chacune une topologie identique à au moins une partie d'un chemin extrait,
- un dispositif de contrôle de mesure pour effectuer au moins une première mesure d'une grandeur physique sur ladite au moins une structure de test dégradée et au moins une deuxième mesure, identique à la première mesure, sur ladite au moins une structure de test non dégradée.

Selon une variante particulière de l'invention, chaque structure de test comprend des cellules logiques combinatoires et des cellules logiques de mémorisation.

Selon une variante particulière de l'invention, le dispositif de contrôle du circuit intégré de caractérisation comprend un dispositif de contrôle de la température d'au moins une structure de test.

Selon une variante particulière de l'invention, le dispositif de contrôle du circuit intégré de caractérisation comprend un générateur de stimuli destinés à être injectés en un point d'entrée d'au moins une structure de test.

Selon une variante particulière de l'invention, le dispositif de contrôle du circuit intégré de caractérisation comprend un dispositif de contrôle de la tension d'alimentation d'au moins une structure de test.

Selon une variante particulière, le système selon l'invention comprend en outre un dispositif d'estimation configuré pour déterminer, à partir des mesures fournies par le dispositif de mesure, une estimation d'une variation dans le temps d'au moins une grandeur physique du circuit intégré d'application.

Selon une variante particulière de l'invention, la grandeur physique est un temps de propagation et le dispositif de contrôle de mesure est apte à mesurer un temps de propagation d'un signal entre deux cellules logiques de mémorisation.

Selon une variante particulière de l'invention, la grandeur physique est un courant consommé et le circuit intégré de caractérisation comporte en outre, pour chaque structure de test, un dispositif de mesure du courant consommé dans la structure de test apte à coopérer avec le dispositif de contrôle de mesure.

L'invention a aussi pour objet un procédé de test d'un circuit intégré d'application représenté par une description comprenant un ensemble de chemins reliant plusieurs cellules logiques, le procédé étant mis en oeuvre au moyen d'un système de test comprenant un circuit intégré de caractérisation comprenant au moins deux structures de test configurables, chacune comprenant une pluralité de cellules logiques activables et une pluralité de connecteurs pour activer et interconnecter les cellules logiques et un ensemble de test, le procédé comprenant les étapes de :

- faire varier au moins un paramètre physique d'au moins une structure de test configurable pour accélérer son vieillissement de sorte à obtenir au moins une structure de test dégradée,
- recevoir une description d'un circuit intégré d'application et extraire au moins un chemin de la description,
- activer et interconnecter au moins un sous-ensemble des cellules logiques d'au moins une structure de test dégradée et d'au moins une structure de test non dégradée, pour qu'elles réalisent chacune une topologie identique à au moins une partie d'un chemin extrait,
- effectuer au moins une première mesure d'une grandeur physique sur ladite au moins une structure de test dégradée et au moins une deuxième mesure, identique à la première mesure, sur ladite au moins une structure de test non dégradée.

Selon un aspect particulier du procédé selon l'invention, la partie du chemin extrait de la description du circuit intégré d'application comprend au moins trois cellules logiques connectées en série.

Selon un aspect particulier du procédé selon l'invention, ledit sous-ensemble de cellules logiques activées et interconnectées comprend en outre :

- Une cellule logique de mémorisation supplémentaire connectée en amont des trois cellules logiques extraites si la première cellule logique de la partie du chemin extrait n'est pas une cellule logique de mémorisation,
- Une cellule logique de mémorisation supplémentaire connectée en aval des trois cellules logiques extraites si la dernière cellule logique de la partie du chemin extrait n'est pas une cellule logique de mémorisation.

Selon un aspect particulier du procédé selon l'invention, la mesure d'au moins une grandeur physique est réalisée au moins sur une cellule logique de mémorisation dudit sous-ensemble.

Selon un aspect particulier du procédé selon l'invention, le procédé est itéré en faisant varier la partie du chemin extrait selon une fenêtre glissante pour parcourir tout le chemin.

Selon un aspect particulier du procédé selon l'invention, ledit paramètre physique est pris parmi une température du circuit, une tension d'alimentation, un stimulus injecté en entrée du circuit de nature et de durée variables.

Selon une variante particulière, le procédé selon l'invention comprend en outre une estimation d'une variation dans le temps d'au moins une grandeur physique du circuit intégré d'application à partir des mesures réalisées sur ladite au moins une structure de test dégradée et sur ladite au moins une structure de test non dégradée.

Selon une variante particulière, l'estimation comprend le calcul de la différence entre deux mesures identiques réalisées sur ladite au moins une structure de test dégradée et sur ladite au moins une structure de test non dégradée.

Selon une variante particulière, l'estimation comprend le calcul d'un ratio entre une somme des différences entre deux mesures identiques réalisées sur ladite au moins une structure de test dégradée et sur ladite au moins une structure de test non dégradée et une somme des mesures réalisées sur ladite au moins une structure de test non dégradée.

Selon un aspect particulier du procédé selon l'invention, la grandeur physique est un temps de propagation ou un courant consommé.

D'autres caractéristiques et avantages de la présente invention apparaîtront mieux à la lecture de la description qui suit en relation aux dessins annexés qui représentent :

- La figure 1, un schéma synoptique d'un système de test d'un circuit intégré selon l'invention,
- La figure 2, un schéma d'une structure de test selon l'invention,
- La figure 3, un schéma illustrant plusieurs agencements possibles de cellules dans une structure de test selon un premier mode de fonctionnement,
- La figure 4, un schéma illustrant plusieurs agencements possibles de cellules dans une structure de test selon un second mode de fonctionnement,
- La figure 5, un schéma illustrant un agencement possible de deux structures de test au sein d'un circuit de caractérisation,
- La figure 6, un organigramme détaillant les étapes de mise en œuvre d'un procédé de test d'un circuit intégré selon l'invention,
- La figure 7, une courbe d'approximation utilisée pour estimer un temps de propagation, dans un mode particulier de réalisation de l'invention,
- La figure 8, un schéma illustrant une structure de test dans une variante de réalisation de l'invention appliquée à l'estimation de la variation du courant consommé dans le circuit,

- La figure 9, un schéma d'un système de test d'un circuit intégré selon une variante de l'invention appliquée à l'estimation de la variation du courant consommé dans le circuit.

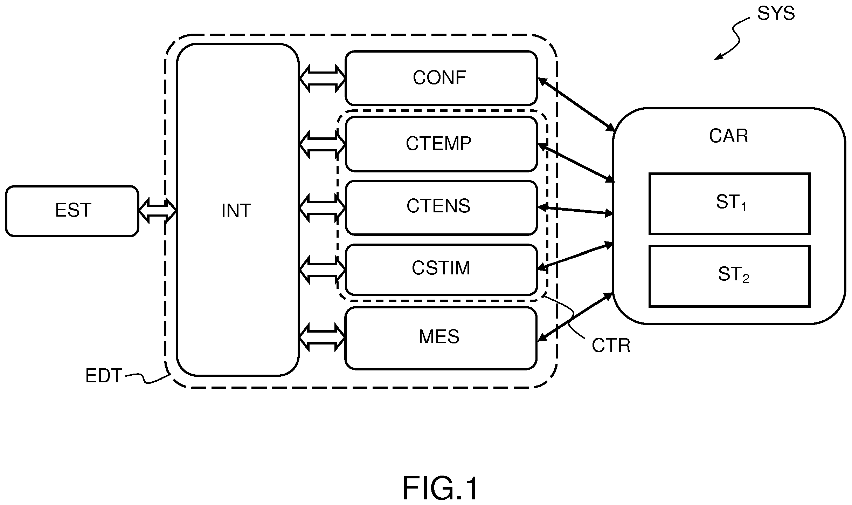

La figure 1 représente un schéma synoptique d'un système de test SYS selon l'invention qui comprend principalement un circuit de caractérisation CAR et un ensemble de test EDT. Le système de test est en outre connecté à un dispositif d'estimation EST via une liaison de communication qui peut être une liaison filaire, une liaison sans fils ou un réseau de communication, par exemple le réseau internet. Dans un mode de réalisation de l'invention, le dispositif d'estimation EST peut être intégré au système de test SYS. Dans un autre mode de réalisation de l'invention, le dispositif d'estimation EST peut être distant du système de test SYS.

Le circuit de caractérisation CAR comporte une pluralité de structures de test ST1,ST2. En particulier, le nombre de structures de test implémentées dans un circuit de caractérisation doit être suffisant pour prendre en compte les effets de la variabilité du procédé de fabrication.

Le circuit de caractérisation CAR peut être fabriqué dans n'importe quelle technologie de fabrication associée à un fabricant de semi-conducteurs. Un exemple de technologie de fabrication est la technologie dite « bulk 40nm low-power ».

La technologie de fabrication définit une bibliothèque de cellules logiques standards. Chaque cellule définit une fonction, par exemple une porte logique du type AND, OR ou NAND, ou encore un inverseur ou une bascule ou toute autre fonction logique. Ces cellules logiques peuvent être combinées entre elles par des outils d'aide à la conception.

Les cellules logiques sont principalement de deux types. Les cellules logiques combinatoires réalisent des fonctions logiques, par exemple des fonctions logiques booléennes, tandis que les cellules logiques de mémorisation réalisent des fonctions de mémorisation du type bascules et verrous.

Chaque structure de test ST1,ST2 comporte plusieurs cellules logiques définies selon la technologie de fabrication choisie et plusieurs moyens d'activation et d'interconnexion de ces cellules entre elles. Un exemple d'un tel moyen est un interrupteur. Un circuit de caractérisation comporte au moins deux structures de test identiques. Chaque structure de test est configurable pour activer et interconnecter certaines cellules logiques. La configuration d'une structure de test se fait par le pilotage des moyens d'activation et d'interconnexion.

Le système de test selon l'invention comporte également un ensemble de test qui comporte au moins un dispositif de configuration CONF du circuit intégré de caractérisation CAR, un dispositif de contrôle CTR du circuit intégré de caractérisation CAR, un dispositif de mesure MES pour mesurer une grandeur physique interne au circuit intégré de caractérisation CAR et une interface INT (ou contrôleur) pour l'échange d'informations entre le dispositif d'estimation EST et l'ensemble de test EDT.

Le dispositif de configuration CONF sert à configurer chaque structure de test à partir d'éléments de description du circuit intégré d'application à concevoir.

Le dispositif de contrôle CTR sert à faire varier au moins un paramètre physique d'au moins une structure de test pour provoquer un vieillissement accéléré des composants de cette structure de test.

Le dispositif de contrôle CTR peut comprendre un dispositif de contrôle de la température CTEMP, par exemple un chauffeur associé à un capteur de température. Il peut comprendre également un générateur de stimuli GSTIM pour générer et injecter en entrée d'une structure de test un signal d'une forme donnée pendant une durée donnée. Il peut également comprendre un dispositif de contrôle de la tension d'alimentation CTENS de la structure de test.

Différentes variantes de réalisation du système de test SYS sont possibles. Dans une première variante, l'ensemble de test EDT peut être intégré directement dans le circuit intégré de caractérisation CAR.

Dans une deuxième variante, l'ensemble de test EDT peut être implanté sur une carte électronique qui contient également le circuit intégré de caractérisation CAR.

Dans ces deux premières variantes, le circuit intégré de caractérisation peut être encapsulé.

Dans une troisième variante, l'ensemble de test EDT est séparé du circuit intégré de caractérisation CAR.

Les deux premières variantes présentent l'avantage de proposer un dispositif intégré compact qui ne nécessite pas d'équipements de tests séparés. La deuxième variante présente aussi l'avantage d'être moins complexe à mettre en œuvre que la première variante.

La troisième variante présente l'avantage de permettre des mesures précises sur le circuit intégré de caractérisation sans avoir recours à des efforts de conception et d'intégration de l'ensemble de test dans une puce ou une carte électronique.

Le dispositif d'estimation EST peut être mis en œuvre par des moyens logiciels, par exemple sous la forme d'un logiciel client destiné à l'ingénieur de conception. Le logiciel client peut se connecter à distance au système de test SYS via un serveur distant auquel est relié le système.

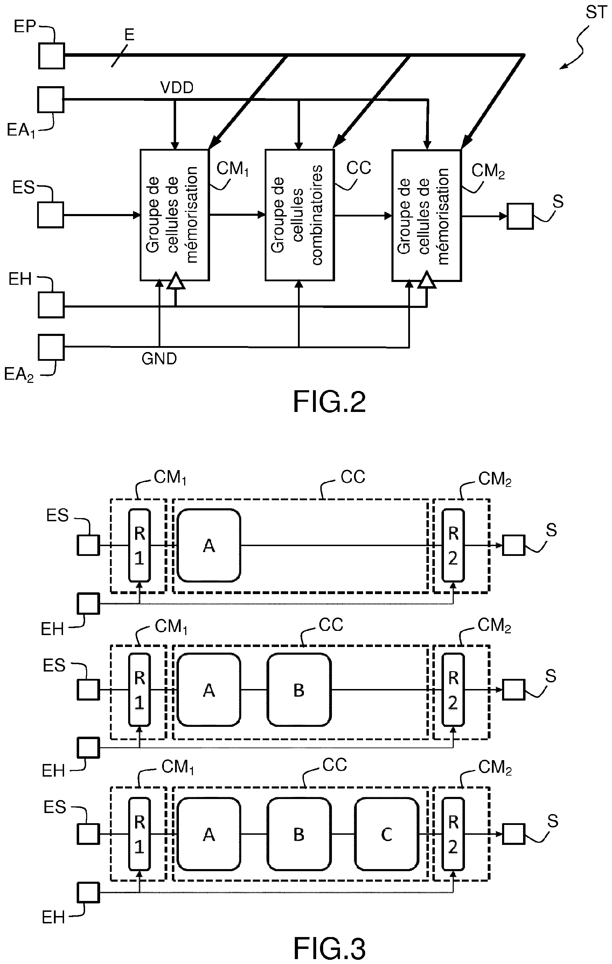

La figure 2 représente un schéma d'une structure de test ST selon l'invention.

Une structure de test comprend plusieurs cellules logiques et plusieurs moyens d'activation et d'interconnexion. Un exemple possible de moyen d'activation et d'interconnexion est un interrupteur. La suite de la description est faite en considérant cet exemple, étant entendu que l'invention ne se limite pas à ce cas particulier de réalisation. Un interrupteur électronique peut être réalisé par exemple en utilisant la technologie dite « pass gâte ». Cependant, l'invention ne se limite pas à l'utilisation d'interrupteurs pour réaliser la fonction d'activation et d'interconnexion des cellules, cette fonction pouvant être réalisée par d'autres composants.

Une cellule logique dispose d'une sortie et d'au moins une entrée sur laquelle peut être injecté un signal d'information transportant un message binaire. Une cellule logique dispose également de deux contacts d'alimentation.

Une structure de test comprend au moins deux groupes de cellules de mémorisation CM1,CM2 et un groupe de cellules combinatoires CC comme représenté sur la figure 2. Chaque groupe de cellules contient au moins une cellule et au moins un interrupteur.

La structure de test ST comprend également plusieurs entrées de programmation EP pour la configuration de l'agencement des cellules logiques, au moins deux entrées d'alimentation EA1,EA2, une entrée d'horloge EH, une entrée de signal ES et une sortie de signal S.

Les entrées de programmation servent à activer certains interrupteurs afin de configurer un agencement particulier de cellules connectées en série.

Selon un mode de réalisation particulier, les moyens d'activation et d'interconnexion peuvent comprendre deux interrupteurs pour chaque cellule. Un premier interrupteur est utilisé pour commander l'activation d'une cellule. A cet effet, il peut être connecté entre la borne d'alimentation d'une cellule et une borne d'alimentation EA1 de la structure de test. Un second interrupteur est utilisé pour commander la connexion d'une cellule à une autre.

Chaque entrée de programmation EP peut commander un interrupteur. Avantageusement, un décodeur d'adresse permet de réduire le nombre d'entrées de programmation et de réduire ainsi le nombre de bornes à prévoir sur le circuit intégré de caractérisation.

L'entrée ES et la sortie S de signal servent respectivement à l'injection et la mesure d'un signal ou stimulus de tests dans les cellules préalablement connectées entre elles au moyen des interrupteurs et à partir de la configuration transmise via les entrées de programmation EP.

La configuration d'une structure de test consiste notamment à :

- activer une cellule de mémorisation parmi les cellules disponibles dans un premier groupe de cellules de mémorisation CM1,
- activer au moins une cellule logique combinatoire parmi celles présentes dans le groupe de cellules combinatoires CC,
- activer une cellule de mémorisation parmi les cellules disponibles dans le second groupe de cellules de mémorisation CM2,
- connecter les cellules activées aux bornes d'entrée de signal ES et de sortie S.

La figure 3 représente, sur un même schéma, trois exemples d'agencements en série de plusieurs cellules logiques.

Dans les trois exemples représentés à la figure 3, chaque groupe de cellules de mémorisation CM1,CM2 comprend chacun une cellule de mémorisation R1,R2.

Le groupe de cellules combinatoires CC comprend de une à trois cellules combinatoires A,B,C connectées en série.

Ces agencements particuliers sont utilisés dans un mode de réalisation du procédé de test selon l'invention qui sera décrit en détail plus loin dans le texte.

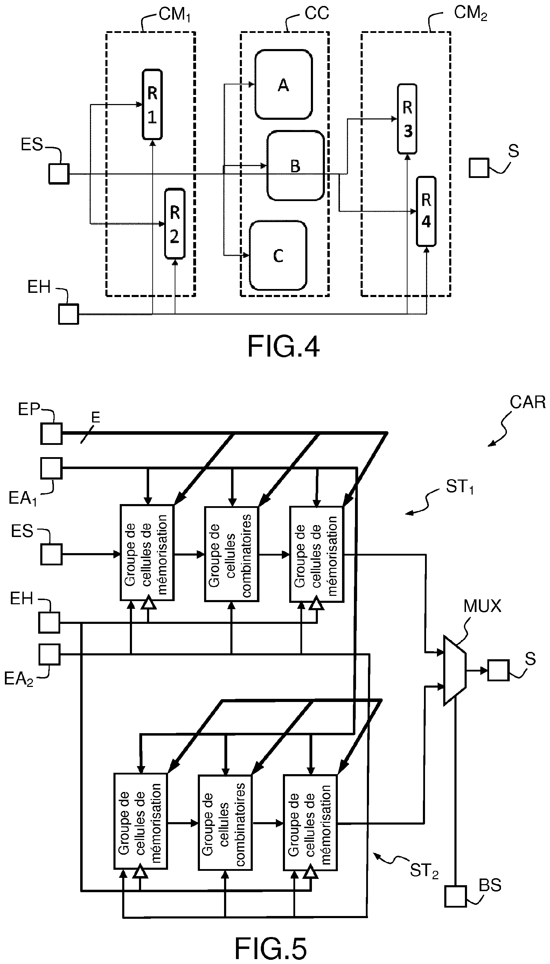

La figure 4 représente un autre exemple d'agencement, en parallèle, de plusieurs cellules logiques.

Dans cet exemple, le premier groupe de cellules de mémorisation CM1 comprend deux cellules de mémorisation R1,R2 connectées en parallèles à l'entrée de signal ES.

Le second groupe de cellules de mémorisation CM2 comprend deux cellules de mémorisation R3,R4 connectées en parallèles à l'entrée de signal ES.

Le groupe de cellules combinatoires CC comprend trois cellules combinatoires A,B,C connectées en parallèles à l'entrée de signal ES.

Selon cet agencement, toutes les cellules sont connectées en parallèle à l'entrée de signal ES. Les autres entrées éventuelles des cellules sont forcés à une valeur fixe '0' ou '1'. Les sorties des cellules ne sont pas connectées. Les contacts d'alimentation des cellules sont connectés à la même borne d'alimentation.

L'agencement particulier de la figure 4 est exploité dans une étape particulière du procédé de test selon l'invention.

La figure 5 représente un ensemble de deux structures de test agencées au sein d'un circuit intégré de caractérisation.

Selon une première variante de réalisation décrite à la figure 5, les deux structures de test ST1,ST2 partagent les mêmes bornes d'entrée et de sortie du circuit intégré de caractérisation. Le nombre de structures de test ainsi connectées en parallèle peut être supérieur à deux.

Les sorties des structures de test sont reliées à un multiplexeur MUX associé à une borne de sélection qui contrôle la connexion de la sortie de l'une des structures de test à la sortie du circuit intégré de caractérisation.

Ainsi, les structures de test ST1,ST2 peuvent recevoir simultanément la même configuration sur les entrées de programmation et les mêmes signaux sur l'entrée de signal.

Selon une seconde variante de réalisation non représentée à la figure 5, les entrées et sorties des structures de test sont physiquement séparées les unes des autres, autrement dit, elles sont connectées à des bornes distinctes du circuit intégré de caractérisation.

Les deux variantes précitées peuvent également être combinées sur un même circuit intégré de caractérisation.

Selon un mode particulier de l'invention, les structures de test peuvent inclure des dispositifs de chauffe pour augmenter la température de jonction des transistors des cellules logiques ainsi que des capteurs de température. Les dispositifs de chauffe et capteurs sont alors reliés au dispositif de contrôle de température CTEMP de l'ensemble de test EDT.

Un circuit intégré de caractérisation peut comprendre une ou plusieurs paires de structures de test. Le nombre de structures de test dépend du coût de réalisation et du rendement de fabrication.

Plusieurs circuits intégrés de caractérisation peuvent être réalisés selon différentes technologies de fabrication. La spécification du circuit intégré de caractérisation développé pour une première technologie peut être réutilisée pour adresser une autre technologie.

L'invention peut reposer sur l'utilisation d'une seule puce de test comprenant un système de test. Avantageusement, l'invention peut également utiliser plusieurs puces identiques issues de différentes positions d'un même wafer et/ou de différents wafers. Après fabrication, les circuits intégrés de caractérisation sont testés pour des défauts de fabrication. Seules les puces exemptes de défauts sont retenues.

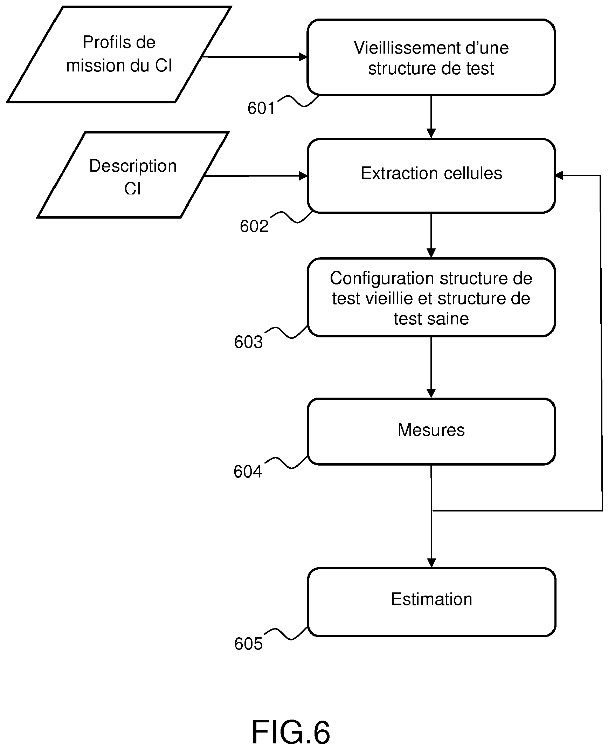

On décrit à présent, à l'appui de la figure 6, un exemple de réalisation d'un procédé de test d'un circuit intégré d'application, selon l'invention, qui utilise le système de test SYS décrit ci-dessus.

Une première étape 601 du procédé consiste à mettre en œuvre un protocole dit de « stress » pour accélérer l'activation de phénomènes liés au vieillissement des transistors qui composent les cellules logiques d'une structure de test. Cette première étape 601 est appliquée à au moins une structure de test du circuit intégré de caractérisation mais peut, avantageusement, être appliquée à plusieurs structures de test.

Un protocole de stress a pour but de faire varier au moins un paramètre physique d'une structure de test afin d'accélérer son vieillissement et d'obtenir une structure de test dégradée qui est susceptible de reproduire les défauts qui peuvent apparaitre sur un circuit au cours du temps.

Le paramètre physique à faire varier peut, par exemple, être choisi parmi les quatre paramètres suivants : la température interne du circuit, la tension d'alimentation du circuit, la forme d'un stimulus (signal) injecté dans le circuit, la durée pendant laquelle le circuit est soumis à la variation de l'un des paramètres précédents.

Un protocole de stress peut comprendre la variation d'un ou plusieurs paramètres physiques de la structure de test. Il peut être défini à partir d'un profil de mission qui est choisi par l'utilisateur du système qui peut être un ingénieur de conception. Le profil de mission est choisi notamment en fonction de standards de test qui sont définis à partir de la connaissance de la physique du vieillissement d'un circuit.

Les stimuli injectés en entrée de la structure de test peuvent notamment prendre trois formes différentes. Un premier stimulus correspond à un signal de valeur '0' constante injecté sur l'entrée de toutes les cellules pendant une durée donnée. Un autre stimulus correspond à un signal de valeur '1' constante. Un autre stimulus correspond à un signal alternant les valeurs '0' et '1'.

Avantageusement, le protocole de stress 601 est appliqué à une structure de test configurée selon l'agencement décrit à la figure 4. Ainsi, un stimulus peut être injecté, via la borne d'entrée de la structure de test, directement dans chaque cellule combinatoire.

Une fois que l'étape 601 est appliquée à une structure de test, celle-ci est artificiellement dégradée ou usée. L'étape 601 est mise en œuvre à l'aide de l'ensemble de test EDT décrit à la figure 1 et en particulier à l'aide du dispositif de contrôle CTR.

Les étapes suivantes 602,603,604,605 décrivent un procédé permettant d'estimer une variation, dans le temps, de certaines grandeurs physiques caractéristiques d'un circuit intégré d'application que l'utilisateur souhaite concevoir.

Dans un premier mode de réalisation, la grandeur physique visée est un temps de propagation d'un signal dans le circuit.

Un point d'entrée du procédé est une description du circuit intégré d'application visé et plus précisément une liste de l'ensemble des chemins implémentés par le circuit intégré. Un chemin est un ensemble de cellules logiques traversées par un signal qui se propage depuis un point d'entrée du circuit vers un point de sortie du circuit. Un signal peut être un signal montant (c'est-à-dire un signal effectuant une transition de l'état '0' vers l'état '1') ou un signal descendant (c'est-à-dire un signal effectuant une transition de l'état '1' vers l'état '0'). Un point d'entrée du circuit peut être une cellule de mémorisation ou une borne d'entrée. De même un point de sortie du circuit peut être une cellule de mémorisation ou une borne de sortie. Il existe au moins un chemin dans un circuit intégré. Un chemin est décrit par la référence des cellules logiques qui le compose. Chaque cellule dispose d'une référence unique qui indique l'origine du fabricant, la fonction réalisée, le nombre de transistors internes, le nombre d'entrées...

La liste des chemins est obtenue généralement avec l'aide d'une synthèse logique qui transforme une description de type VHDL ou VERILOG abstraite du circuit intégré vers une description de type « porte ». La transformation s'appuie sur la bibliothèque du fabricant du circuit. Ainsi, la description des chemins contient seulement des cellules standards de cette bibliothèque.

Classiquement, le procédé de fabrication d'un circuit intégré d'application comprend :

A- Une phase de modélisation du circuit (sur le plan matériel et logiciel) dans laquelle le circuit est modélisé à très haut niveau;

B- Une phase de description en langage haut niveau, après validation de l'architecture en phase de modélisation, dans laquelle l'implémentation du circuit est décrite au niveau transfert de registres (RTL) sous forme d'éléments séquentiels (registres, bascules) et d'éléments combinatoires logiques correspondant aux combinaisons entre les entrées/sorties des éléments séquentiels et les entrées/sorties principales du circuit ; cette description, appelée « description comportementale », est codée à l'aide d'un langage de programmation haut niveau (par exemple VHDL, VERILOG, etc.) ;

C- Une phase de simulation logique pour simuler la description en utilisant un simulateur. Le simulateur simule dans le temps chaque signal d'interconnexion en fonction d'un stimulus d'entrée décrit au préalable;

D- Une phase de vérification fonctionnelle peut être mise en œuvre en complément de la simulation notamment pour simuler des durées de fonctionnement plus importantes, en utilisant des langages basés sur une modélisation par assertion pour définir les propriétés fonctionnelles que doit vérifier le circuit ;

E- Une phase de synthèse logique dans laquelle la description comportementale du circuit est transformée en une description structurelle au niveau des portes logiques (« netlist »), à partir d'une bibliothèque de portes logiques (par exemple portes ET, OU, Bascules, etc.) spécifique à la technologie visée et/ou au fondeur qui fabriquera le circuit. La synthèse logique peut être mise en œuvre au moyen d'un outil EDA configuré pour transformer la description comportementale en langage haut niveau en description structurelle générique (indépendamment de la bibliothèque de portes logiques) en décrivant les éléments logiques combinatoires et séquentiels sous forme générique, puis en les remplaçant par des éléments de la bibliothèque de portes logiques de manière à respecter des conditions portant sur les caractéristiques du circuit (e.g. chemins logiques du circuits) par rapport à des contraintes de temps (par exemple, fréquence de fonctionnement du circuit) et d'espace (taille en silicium). À l'issue de la synthèse logique, un fichier informatique correspondant à la description structurelle peut être obtenu dans un format choisi tel que Verilog, VHDL, EDIF. Ce fichier correspondant au circuit intégré représente l'instanciation des portes de la bibliothèque et leur interconnexion (« netlist ») ;

F- Le circuit peut être ensuite fabriqué en usine.

La description du circuit d'application peut être dérivée de l'une quelconque des descriptions du circuit obtenues dans les différentes phases du flot de conception. Dans certains modes de réalisation, la description du circuit d'application peut être une description structurelle de l'étape E du circuit intégré d'application parmi les descriptions possibles : « netlist » logique ou « netlist » physique.

Les étapes 602,603 et 604 qui suivent peuvent être itérées pour plusieurs chemins extraits de la description du circuit intégré d'application. Avantageusement, tous les chemins sont traités dans l'ordre du plus long au plus court. La longueur est déterminée par exemple par le nombre de cellules composant ce chemin. Alternativement, la longueur peut être également déterminée par le temps de propagation estimé avec l'aide d'outils logiciels et de bibliothèques de valeurs fournies par le fabricant de semi-conducteur.

Dans un mode de réalisation de l'invention, l'intégralité des cellules composant un chemin peut être transmis et traité directement par l'étape de configuration 603. Ce mode de réalisation concerne notamment des cas d'application où le circuit intégré de caractérisation n'est pas contraint en dimension et le circuit d'application contient peu de chemins.

Dans un autre mode de réalisation, afin de limiter les dimensions du circuit intégré de caractérisation, il est possible de traiter un chemin par une boucle itérative en utilisant une fenêtre glissante comprenant un nombre limité de cellules logiques.

L'étape 602 consiste ainsi à extraire, via une fenêtre de sélection, un ensemble de cellules logiques du chemin, en commençant par le point d'entrée du chemin. Aux itérations suivantes, la fenêtre de sélection est déplacée vers la sortie du chemin d'une cellule à la fois. La fenêtre de sélection contient au moins trois cellules logiques. Lorsque les trois cellules logiques extraites du chemin ne comprennent pas de cellule de mémorisation au début de la séquence, on ajoute une cellule de mémorisation au début de la fenêtre qui comprend alors au moins quatre cellules. De même, lorsque les trois cellules logiques extraites du chemin ne comprennent pas de cellule de mémorisation à la fin de la séquence, on ajoute une cellule de mémorisation à la fin de la fenêtre qui comprend alors au moins quatre cellules.

Par exemple, on peut considérer un chemin composé de cinq cellules ordonnées de la manière suivante : A, B, C, D et E. Dans la première itération de l'étape 602, le procédé sélectionne les cellules A, B et C. Dans la seconde itération de l'étape 602, le procédé sélectionne les cellules B, C et D. Dans la troisième itération de l'étape 602, le procédé sélectionne les cellules C, D et E. Dans cet exemple, les cellules A et E sont des cellules de mémorisation.

L'étape 603 consiste ensuite à configurer au moins une structure de test dégradée par application de l'étape 601 et au moins une structure de test saine, c'est-à-dire non dégradée, pour que chacune de ces structures de test reproduisent l'agencement de cellules extraites dans la fenêtre de sélection.

L'étape 603 est exécutée par le dispositif de configuration CONF de l'ensemble de test EDT qui reçoit les chemins de la description du circuit intégré d'application via l'interface INT.

Un exemple de réalisation de l'étape 603 consiste à récupérer la référence de chaque cellule extraite. Le procédé dispose, par exemple, d'une table associative T1 appelée table de configuration qui a été préalablement remplie lors de la conception du circuit de caractérisation CAR. L'index de la table T1 est la référence d'une cellule dans le circuit de caractérisation. Pour chaque cellule, la table T1 contient une adresse qui indique le numéro des entrées de programmation EP à contrôler. Pour chaque référence, le procédé cherche l'entrée de la table correspondante puis contrôle les entrées de programmation trouvées dans l'entrée de la table pour activer les interrupteurs correspondants. La table T1 est préférablement stockée dans une mémoire non volatile du circuit intégré de caractérisation. Par exemple, le dispositif de configuration CONF reçoit la description des chemins via l'interface INT puis vient lire la table T1 pour appliquer la configuration correspondante à la fenêtre de sélection aux structures de test choisies.

Dans une étape 604, le procédé réalise des mesures sur les structures de test configurées via l'étape 603 qui comprennent au moins une structure de test dégradée et au moins une structure de test saine.

Dans le cas où plusieurs structures de test dégradées sont utilisées, chaque structure de test dégradée peut avoir été soumise à un protocole de stress ayant des paramètres différents, par exemple des formes de stimuli différentes.

Dans un premier mode de réalisation de l'invention, les mesures réalisées concernent des mesures de temps de propagation. On mesure, sur chaque structure de test, un temps de propagation pour un signal injecté en entrée du groupe de cellules sélectionnées à l'étape 602 et mesuré en sortie de ce groupe de cellules. Avantageusement, la mesure de temps de propagation est effectuée au niveau de la cellule de mémorisation de sortie. On mesure un temps de propagation dit « montant » correspondant à la propagation d'un signal montant (passant de l'état '0' à l'état '1'). On mesure également un temps de propagation dit « descendant » correspondant à la propagation d'un signal descendant (passant de l'état '1' à l'état '0').

Le temps de propagation dans une structure de test désigne le temps que met un signal pour passer de la cellule de mémorisation d'entrée de la structure de test à la cellule de mémorisation de sortie de la structure de test. Une réalisation possible de ces mesures est basée sur la technique de la recherche de la fréquence maximale de la structure de test ou technique dite « at-speed ».

Dans le cas du circuit intégré de caractérisation, l'objectif est de déterminer le temps de propagation d'un signal se propageant à travers les cellules activées. La mesure de ce temps repose sur l'utilisation d'un générateur d'horloge qui produit un signal périodique dont la fréquence est programmable et du générateur de stimuli. Quelle que soit la configuration envisagée de la structure de test, le procédé nécessite l'activation d'une cellule de mémorisation dans chacun des deux groupes de cellules de mémorisation CM1,CM2.

La suite du paragraphe décrit un exemple de procédé permettant la mesure du temps de propagation montant. Les étapes décrites pourront être appliquées de façon identique à la mesure du temps de propagation descendant.

La mesure repose sur la propagation d'une transition montante à travers la cellule située au centre de la fenêtre glissante. Dans le cas d'une fenêtre glissante comprenant trois cellules extraites d'un chemin, la cellule située au centre de la fenêtre glissante est la seconde cellule du groupe de trois cellules.

La mesure peut être réalisée via les étapes suivantes :

1. Programmation de la plus grande fréquence disponible dans le générateur d'horloge,
2. Application d'un signal d'horloge périodique sur les entrées dédiées des cellules de mémorisation,
3. Initialisation des cellules de mémorisation actives à la valeur '0',
4. Au premier front d'horloge, une valeur '0' est appliquée à l'entrée de signal ES de la structure de test, la valeur '0' est observée sur la sortie S,
5. Au second front d'horloge, une valeur '1' est appliquée sur l'entrée de signal ES de la structure de test, la valeur '0' est observée sur la sortie S,
6. Au troisième front d'horloge, la valeur '1' est maintenue sur l'entrée de signal ES, la sortie S peut prendre deux valeurs possibles :

   a. Si la valeur observée est '1', cela signifie que le temps de propagation est inférieur à la période d'horloge programmée (inverse de la fréquence). Dans ce cas, on choisi une valeur de fréquence d'horloge supérieure à l'aide d'une méthode par dichotomie et on itère le procédé en retournant à l'étape 3.
   b. Si la valeur observée est '0', cela signifie que le temps de propagation est supérieur à la période d'horloge programmée. Dans ce cas, on choisi une valeur de fréquence d'horloge inférieure avec l'aide d'une méthode par dichotomie et on itère le procédé en retournant à l'étape 3.

Le procédé s'arrête lorsque la différence entre la valeur de fréquence obtenue (Fob) et la valeur de fréquence actuelle (Fac) est inférieure au pas de programmation (incrément ou décrément minimal) du générateur d'horloge. La valeur de temps de propagation montant (tm) peut être obtenue à l'aide de la formule suivante :

$$tm = \frac{2}{\dfrac{1}{F_{ac}} + \dfrac{1}{F_{ob}}}$$

Le procédé décrit ci dessus correspond au cas d'une cellule logique combinatoire sans inversion. Dans le cas où la sortie d'une cellule prend l'inverse de la valeur en entrée, les valeurs appliquées sur l'entrée de signal ES doivent être complémentées ('0' devient '1' et inversement).

L'invention ne se limite pas, pour mesurer un temps de propagation, à la méthode décrite ci-dessus. Toute autre méthode permettant de mesurer un temps de propagation montant et descendant entre l'entrée et la sortie d'une structure de test, est compatible de l'invention. En particulier, toute méthode utilisant des capteurs de délai permettant de détecter la variation du temps de propagation de signaux entre deux cellules de mémorisation est envisageable.

Les étapes 602,603,604 sont itérées en faisant glisser la fenêtre de sélection progressivement d'une cellule à chaque itération jusqu'à la fin d'un chemin.

A l'issue de l'étape 604, on obtient un ensemble de mesures qui peuvent être stockées dans une ou plusieurs tables. Par exemple, on peut utiliser une table pour les structures de test dégradées et une autre table pour les structures de test saines. Chaque table peut être indexée par la référence d'une cellule du groupe de cellules sélectionnées à l'étape 602. Chaque entrée de la table mémorise l'ensemble des mesures effectuées qui comprennent au moins une valeur de temps de propagation montant et de temps de propagation descendant. La ou les table(s) peuvent être stockée(s) dans une mémoire du dispositif d'estimation EST. Dans ce cas, les mesures réalisées à l'étape 604 via le dispositif de mesure MES sont transmises au dispositif d'estimation EST via une interface INT.

Pour chaque chemin, on obtient une mesure par cellule dans le cas où on utilise une fenêtre de sélection glissante.

Dans le cas où plusieurs structures de test dégradées sont utilisées, avec des formes de stimuli différentes, pour chaque entrée, la table comprend autant de paires de mesures (temps de propagation montant, temps de propagation descendant) que de structures de test dégradées utilisées.

Dans une étape 605, le dispositif d'estimation EST, qui peut être mis en œuvre par un logiciel interfacé avec le système de test SYS, reçoit les mesures réalisées sur les différences structures de test et applique un ensemble de traitement sur ces mesures afin d'en déduire une estimation a priori de l'évolution dans le temps de la grandeur physique mesurée. Dans le mode de réalisation présentement décrit, la grandeur physique est un temps de propagation, le dispositif d'estimation EST compare les mesures de temps de propagation réalisées d'une part sur les structures de test dégradées et d'autre part sur les structures de test saines.

Les mesures réalisées sur une structure de test dégradée peuvent être corrigées, par le biais de coefficients de pondération, pour prendre en compte l'accélération artificielle du vieillissement de la structure de test et ramener les mesures à des valeurs représentatives de l'effet du vieillissement sur une durée longue.

La comparaison peut être effectuée en calculant la variation relative du temps de propagation mesuré sur une structure de test dégradée par rapport au temps de propagation mesuré sur une structure de test saine.

Lorsqu'une fenêtre de sélection est utilisée pour parcourir un chemin du circuit intégré d'application, les mesures réalisées pour plusieurs positions de la fenêtre de sélection sont agrégées ensemble afin de fournir une mesure unique finale.

A titre d'exemple, une estimation de variation globale du temps de propagation peut être calculée à l'aide de la formule suivante :

$$\Delta t = \frac{\sum t_d(i) - \sum t_s(i)}{\sum t_s(i)}$$

$t_d(i)$ sont les mesures de temps de propagation (montant ou descendant) réalisées sur une structure de test dégradée,

$t_s(i)$ sont les mesures de temps de propagation (montant ou descendant) réalisées sur une structure de test saine.

Dans le cas où on utilise plusieurs structures de test dégradées par l'injection de plusieurs stimuli différents, il est possible de prendre en compte de façon différenciée les mesures réalisées sur ces structures de test dégradées dans le calcul d'estimation final.

Par exemple, il est possible de ne retenir que la variation la plus élevée parmi les variations calculées pour plusieurs structures de test. On peut aussi retenir la moyenne des variations calculées pour plusieurs structures de test ou la moyenne retranchée de l'écart type ou toute autre métrique statistique.

Dans une autre variante de réalisation, le choix de la valeur de temps de propagation retenu peut être guidé par la connaissance de l'activité réelle de l'entrée d'une cellule G faisant partie du chemin traité par le procédé et correspondant à un chemin dans le circuit intégré d'application.

L'activité réelle de chaque cellule peut être obtenue par une simulation logico-temporelle du circuit intégré d'application préalablement effectuée avec des stimuli d'entrées définis par l'utilisateur (par ex : applications exécutées sur un microprocesseur). Les rapports de simulation sont analysés afin d'y calculer l'activité de l'entrée de chaque cellule du circuit intégré d'application. Deux métriques peuvent être utilisées :

- le nombre de commutation par cycle d'horloge, noté TR
- les probabilités à '0' et '1' par cycle d'horloge d'un signal, notées respectivement SP0 et SP1.

Chaque entrée de la cellule G est associée à un triplet de valeur (TR, SP0 et SP1).

Lorsqu'une cellule dispose d'au moins deux entrées, le choix du triplet pour la cellule G est celui de l'entrée traversée par le chemin P.

Dans cette variante de réalisation, la valeur qui sera retenue pour la cellule G est obtenue par une opération d'interpolation à partir de toutes les valeurs contenues, pour cette cellule G, dans la table des mesures faites sur plusieurs structures de test dégradées.

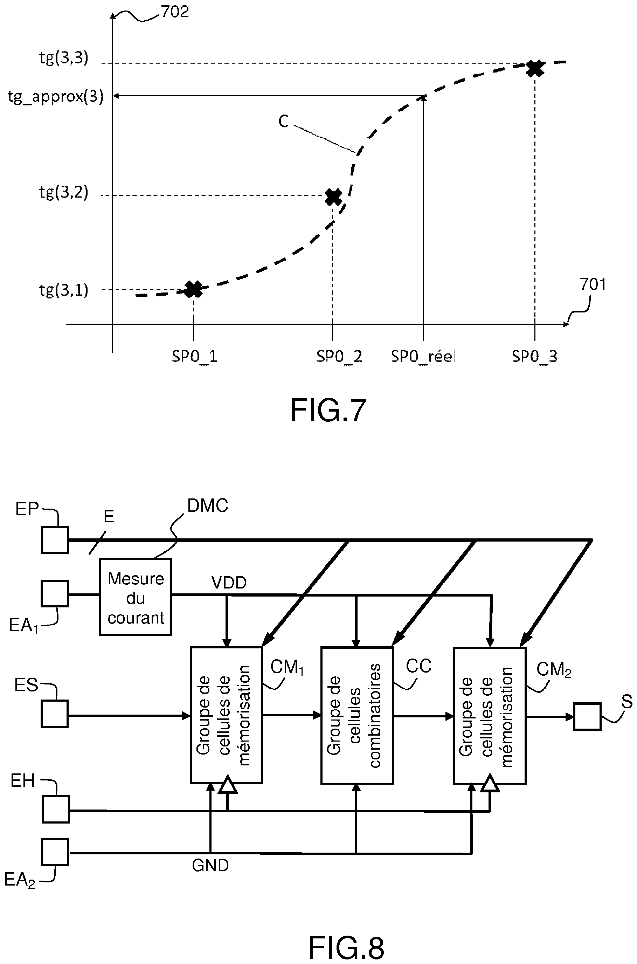

Un exemple de réalisation de l'étape d'interpolation est illustré sur la figure 7 qui représente, sur un diagramme, en abscisse 701, une information sur l'activité de l'entrée d'une cellule G et, en ordonnée 702, les mesures de temps de propagation, pour cette cellule G, obtenues pour plusieurs structures de test dégradées. L'activité en entrée de la cellule est mesurée par une métrique SP0. Les valeurs d'activité SP0_1 ,SP0_2,SP0_3 sont des valeurs de référence associées à trois mesures tg(3,1), tg(3,2), tg(3,3) faites sur trois structures de test dégradées différentes. A partir des trois points de la courbe, on utilise la théorie statistique afin de déterminer la courbe d'approximation C qui passe au plus près de ces trois points.

Ensuite, à partir de la valeur d'activité SP0_réel réellement mesurée sur l'entrée de la cellule G, on obtient une mesure interpolée tg_approx(3).

On décrit à présent un autre mode de réalisation de l'invention dans lequel la grandeur physique mesurée peut être un courant consommé dans une cellule logique et non plus un temps de propagation.

Ce mode de réalisation présente une solution pour estimer la variation du courant consommé par le circuit au cours du temps. La variation est causée par le vieillissement des cellules du circuit. Cette solution s'intéresse au courant statique (lorsque l'entrée de la cellule est dans un état '0' ou '1') et au courant dynamique (lorsqu'une entrée commute de la valeur '0' vers '1' et vice-versa) consommé par les cellules du circuit d'application.

Pour mettre en œuvre ce mode de réalisation, le circuit intégré de caractérisation CAR doit être modifié pour y insérer un dispositif de mesure du courant dans chaque structure de test. Un exemple de structure de test modifiée selon cette variante de l'invention est représenté à la figure 8.

Le dispositif de mesure de courant DMC peut distinguer le courant consommé dans chaque structure de test séparément. Pour cela, le dispositif DMC est inséré dans le rail d'alimentation de chaque structure de test. Le rail d'alimentation de chaque structure de test est physiquement séparé de celui des autres structures. La mesure du courant d'une structure de test est la somme des courants consommés par chaque cellule active dans les trois groupes de cellules CM1,CC,CM2.

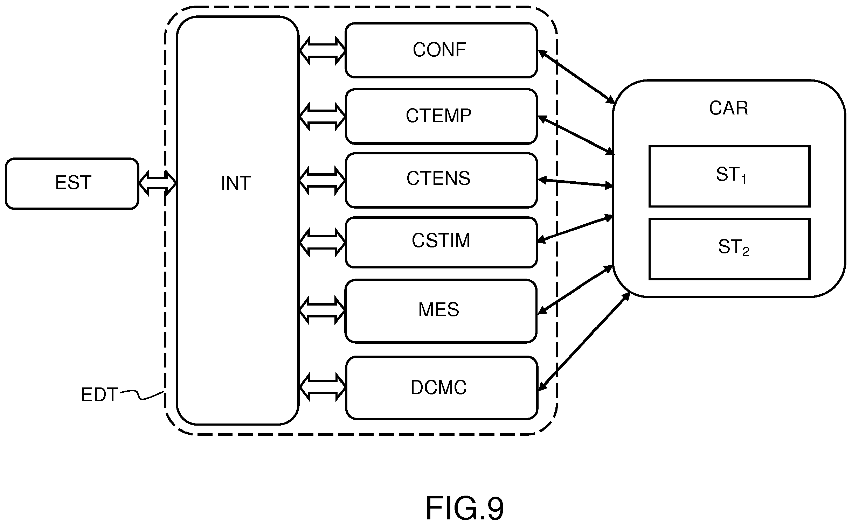

En outre, le système de test SYS selon l'invention doit également être modifié afin d'insérer, dans l'ensemble de test EDT, un dispositif de contrôle DCMC de la mesure du courant consommé dans les structures de test. Ce dispositif DCMC a pour fonction la lecture et la mémorisation des valeurs de courant mesuré dans chaque structure de test séparément. Le système de test SYS modifié selon cette variante de l'invention est représenté à la figure 9.

L'étape de mesure 604 du procédé selon cette variante de réalisation de l'invention consiste notamment d'une part en la mesure d'un courant statique et d'autre part en la mesure d'un courant dynamique.

Le courant statique est mesuré en appliquant un signal constant à l'état '0' sur l'entrée de signal ES de la structure de test. Le courant maximal consommé par la structure de test est mesuré par le dispositif de mesure DMC. Le courant dynamique est mesuré en appliquant, sur l'entrée de signal ES de la structure de test, un signal réalisant une transition de l'état '0' vers l'état '1'. Le courant maximal consommé pendant la phase de commutation de la sortie d'une cellule est mesuré. Lorsqu'une fenêtre de sélection glissante est utilisée, le courant est mesuré dans la cellule du centre de la fenêtre, par exemple la seconde cellule lorsque la fenêtre contient trois cellules.

Les mesures sont stockées et communiquées au dispositif d'estimation EST de la même façon que pour le cas des mesures de temps de propagation.

Le calcul de l'estimation de la variation du courant mesuré est identique à celui du calcul de l'estimation de la variation du temps de propagation précédemment décrit. En d'autres termes, l'étape d'estimation 605 est identique entre les deux variantes de l'invention.

L'invention présente l'avantage de permettre à un utilisateur d'estimer la fiabilité d'un circuit intégré d'application en s'appuyant sur un système de test SYS selon l'invention. La configuration et la manipulation du système peut être cachée à l'utilisateur grâce à l'ensemble de test EDT.

Le système et le procédé de test selon les formes de réalisation de l'invention présentent plusieurs avantages. En particulier, ils permettent une analyse de risque et une prise de décision au plus tôt dans le flot de développement, la mise en œuvre de l'invention pouvant utiliser une description du circuit issue du résultat de la première synthèse logique.

Par ailleurs, ils permettent une estimation précise du niveau de fiabilité global du circuit intégré à réaliser en fonction de son implémentation et du profil de mission.

C'est également un avantage de l'invention de permettre une estimation de fiabilité indépendante des conditions d'accès aux données confidentielles du fabricant semiconducteur. L'invention garantit en outre la non-divulgation des informations confidentielles qui seront extraites du système de test.

En outre, l'estimation ne requiert pas une expertise particulière de la part du concepteur dans le domaine de la fiabilité.

Le système et le procédé de test selon les formes de réalisation de l'invention peuvent appuyer sur des techniques de caractérisation standardisées, et s'appliquent à toute technologie de semi-conducteur quelles que soient les sources de défaillances dans les transistors.

L'homme du métier comprendra que le procédé de test selon les modes de réalisation peut être mis en œuvre de diverses manières par matériel (« hardware »), logiciel, ou une combinaison de matériel et de logiciels, notamment sous la forme de code de programme pouvant être distribué sous la forme d'un produit de programme, sous diverses formes. En particulier, le code de programme peut être distribué à l'aide de supports lisibles par ordinateur, qui peuvent inclure des supports de stockage lisibles par ordinateur et des supports de communication. Les procédés décrits dans la présente description peuvent être notamment implémentés sous la forme d'instructions de programme d'ordinateur exécutables par un ou plusieurs processeurs dans un dispositif informatique d'ordinateur. Ces instructions de programme d'ordinateur peuvent également être stockées dans un support lisible par ordinateur.

L'invention n'est pas limitée aux modes de réalisation décrits ci-avant à titre d'exemple non limitatif. Elle englobe toutes les variantes de réalisation qui pourront être envisagées par l'homme du métier. En particulier, l'invention n'est pas limitée à des types particuliers de cellules logiques ou combinatoires pour réaliser les circuits intégrés de caractérisation.

**Revendications**

1. Système de test (SYS) d'un circuit intégré d'application représenté par une description comprenant un ensemble de chemins reliant plusieurs cellules logiques, le système de test (SYS) comprenant un circuit intégré de caractérisation (CAR) comprenant au moins deux structures de test configurables (ST1,ST2), chacune comprenant une pluralité de cellules logiques activables (A,B,C,R1,R2) et une pluralité de connecteurs pour activer et interconnecter les cellules logiques, et un ensemble de test (EDT) comprenant :

   - un dispositif de contrôle (CTR) du circuit intégré de caractérisation configuré pour faire varier au moins un paramètre physique d'au moins une structure de test configurable pour accélérer son vieillissement de sorte à obtenir au moins une structure de test dégradée,
   - une interface (INT) pour recevoir au moins une description d'un circuit intégré d'application et extraire au moins un chemin de la description,
   - un dispositif de configuration (CONF) du circuit intégré de caractérisation pour activer et interconnecter au moins un sous-ensemble des cellules logiques d'au moins une structure de test dégradée et d'au moins une structure de test non dégradée, pour qu'elles réalisent chacune une topologie identique à au moins une partie d'un chemin extrait,
   - un dispositif de contrôle de mesure (MES) pour effectuer au moins une première mesure d'une grandeur physique sur ladite au moins une structure de test dégradée et au moins une deuxième mesure, identique à la première mesure, sur ladite au moins une structure de test non dégradée.

2. Système de test selon la revendication 1 dans lequel chaque structure de test (ST) comprend des cellules logiques combinatoires (A,B,C) et des cellules logiques de mémorisation (R1,R2).

3. Système de test selon l'une des revendications précédentes dans lequel le dispositif de contrôle (CTR) du circuit intégré de caractérisation comprend un dispositif de contrôle (CTEMP) de la température d'au moins une structure de test.

4. Système de test selon l'une des revendications précédentes dans lequel le dispositif de contrôle (CTR) du circuit intégré de caractérisation comprend un générateur (GSTIM) de stimuli destinés à être injectés en un point d'entrée d'au moins une structure de test.

5. Système de test selon l'une des revendications précédentes dans lequel le dispositif de contrôle (CTR) du circuit intégré de caractérisation comprend un dispositif de contrôle de la tension d'alimentation (CTENS) d'au moins une structure de test.

6. Système de test selon l'une des revendications précédentes dans lequel le système comprend en outre un dispositif d'estimation (EST) configuré pour déterminer, à partir des mesures fournies par le dispositif de mesure, une estimation d'une variation dans le temps d'au moins une grandeur physique du circuit intégré d'application.

7. Système de test selon l'une des revendications précédentes dans lequel la grandeur physique est un temps de propagation et le dispositif de contrôle de mesure (MES) est apte à mesurer un temps de propagation d'un signal entre deux cellules logiques de mémorisation.

8. Système de test selon l'une des revendications 1 à 6 dans lequel la grandeur physique est un courant consommé et le circuit intégré de caractérisation (CAR) comporte en outre, pour chaque structure de test (ST1,ST2), un dispositif de mesure (DMC) du courant consommé dans la structure de test apte à coopérer avec le dispositif de contrôle de mesure (MES).

9. Procédé de test d'un circuit intégré d'application représenté par une description comprenant un ensemble de chemins reliant plusieurs cellules logiques, le procédé étant mis en œuvre au moyen d'un système de test (SYS) comprenant un circuit intégré de caractérisation (CAR) comprenant au moins deux structures de test configurables (ST1,ST2), chacune comprenant une pluralité de cellules logiques activables et une pluralité de connecteurs pour activer et interconnecter les cellules logiques et un ensemble de test (EDT), le procédé comprenant les étapes de :

- faire varier (601) au moins un paramètre physique d'au moins une structure de test configurable pour accélérer son vieillissement de sorte à obtenir au moins une structure de test dégradée,
- recevoir (602) une description d'un circuit intégré d'application et extraire au moins un chemin de la description,
- activer et interconnecter (603) au moins un sous-ensemble des cellules logiques d'au moins une structure de test dégradée et d'au moins une structure de test non dégradée, pour qu'elles réalisent chacune une topologie identique à au moins une partie d'un chemin extrait,
- effectuer (604) au moins une première mesure d'une grandeur physique sur ladite au moins une structure de test dégradée et au moins une deuxième mesure, identique à la première mesure, sur ladite au moins une structure de test non dégradée.

**10.** Procédé de test d'un circuit intégré d'application selon la revendication 9 dans lequel la partie du chemin extrait de la description du circuit intégré d'application comprend au moins trois cellules logiques connectées en série.

**11.** Procédé de test d'un circuit intégré d'application selon la revendication 10 dans lequel ledit sous-ensemble de cellules logiques activées et interconnectées comprend en outre :

- Une cellule logique de mémorisation supplémentaire connectée en amont des trois cellules logiques extraites si la première cellule logique de la partie du chemin extrait n'est pas une cellule logique de mémorisation,
- Une cellule logique de mémorisation supplémentaire connectée en aval des trois cellules logiques extraites si la dernière cellule logique de la partie du chemin extrait n'est pas une cellule logique de mémorisation.

**12.** Procédé de test d'un circuit intégré d'application selon l'une des revendications 10 ou 11 dans lequel la mesure d'au moins une grandeur physique est réalisée au moins sur une cellule logique de mémorisation dudit sous-ensemble.

**13.** Procédé de test d'un circuit intégré d'application selon la revendication 12 dans lequel le procédé est itéré en faisant varier la partie du chemin extrait selon une fenêtre glissante pour parcourir tout le chemin.

**14.** Procédé de test d'un circuit intégré d'application selon l'une des revendications 9 à 13 dans lequel ledit paramètre physique est pris parmi une température du circuit, une tension d'alimentation, un stimulus injecté en entrée du circuit de nature et de durée variables.

**15.** Procédé de test d'un circuit intégré d'application selon l'une des revendications 9 à 14 comprenant en outre une estimation (605) d'une variation dans le temps d'au moins une grandeur physique du circuit intégré d'application à partir des mesures réalisées sur ladite au moins une structure de test dégradée et sur ladite au moins une structure de test non dégradée.

**16.** Procédé de test d'un circuit intégré d'application selon la revendication 15 dans lequel l'estimation (605) comprend le calcul de la différence entre deux mesures identiques réalisées sur ladite au moins une structure de test dégradée et sur ladite au moins une structure de test non dégradée.

**17.** Procédé de test d'un circuit intégré d'application selon la revendication 16 dans lequel l'estimation (605) comprend le calcul d'un ratio entre une somme des différences entre deux mesures identiques réalisées sur ladite au moins une structure de test dégradée et sur ladite au moins une structure de test non dégradée et une somme des mesures réalisées sur ladite au moins une structure de test non dégradée.

**18.** Procédé de test d'un circuit intégré d'application selon la revendication 17 dans lequel la grandeur physique est un temps de propagation ou un courant consommé.

**Patentansprüche**

**1.** System (SYS) zum Testen einer integrierten Anwendungsschaltung, dargestellt durch eine Beschreibung, die einen Satz von Pfaden umfasst, die mehrere Logikzellen verbinden, wobei das Testsystem (SYS) eine integrierte Charakterisierungsschaltung (CAR) mit mindestens zwei konfigurierbaren Teststrukturen (ST1, ST2), jeweils mit mehreren aktivierbaren Logikzellen (A, B, C, R1, R2) und mehreren Verbindern zum Aktivieren und Verbinden der Logikzellen, und einen Testsatz (EDT) umfasst, der Folgendes umfasst:

- eine Vorrichtung (CTR) zum Prüfen der integrierten Charakterisierungsschaltung, konfiguriert um mindestens einen physikalischen Parameter von mindestens einer Teststruktur zu variieren, die zum Beschleunigen ihrer Alterung konfiguriert werden kann, um mindestens eine degradierte Teststruktur zu erhalten,

- eine Schnittstelle (INT) zum Empfangen mindestens einer Beschreibung von einer integrierten Anwendungsschaltung und zum Extrahieren mindestens eines Pfades aus der Beschreibung,

- eine Vorrichtung (CONF) zum Konfigurieren der integrierten Charakterisierungsschaltung zum Aktivieren und Verbinden mindestens eines Teilsatzes von Logikzellen von mindestens einer degradierten Teststruktur und mindestens einer nicht degradierten Teststruktur, um jeweils eine Topologie zu erzielen, die mit mindestens einem Teil eines extrahierten Pfades identisch ist,

- eine Messprüfvorrichtung (MES) zum Durchführen mindestens einer ersten Messung einer physikalischen Größe auf der mindestens einen degradierten Teststruktur und mindestens einer mit der ersten Messung identischen zweiten Messung auf der mindestens einen nicht degradierten Teststruktur.

2. Testsystem nach Anspruch 1, bei dem jede Teststruktur (ST) kombinatorische Logikzellen (A, B, C) und Speicherlogikzellen (R1, R2) umfasst.

3. Testsystem nach einem der vorherigen Ansprüche, bei dem die Vorrichtung (CTR) zum Prüfen der integrierten Charakterisierungsschaltung eine Vorrichtung (CTEMP) zum Prüfen der Temperatur von mindestens einer Teststruktur umfasst.

4. Testsystem nach einem der vorherigen Ansprüche, bei dem die Vorrichtung (CTR) zum Prüfen der integrierten Charakterisierungsschaltung einen Stimulusgenerator (GSTIM) umfasst, bestimmt zum Injizieren in einen Eintrittspunkt von mindestens einer Teststruktur.

5. Testsystem nach einem der vorherigen Ansprüche, bei dem die Vorrichtung (CTR) zum Prüfen der integrierten Charakterisierungsschaltung eine Vorrichtung zum Prüfen der Speisespannung (CTENS) von mindestens einer Teststruktur umfasst.

6. Testsystem nach einem der vorherigen Ansprüche, bei dem das System ferner eine Schätzvorrichtung (EST) umfasst, konfiguriert zum Bestimmen, auf der Basis der von der Messvorrichtung gelieferten Messwerte, einer Schätzung einer zeitlichen Variation mindestens einer physikalischen Größe der integrierten Anwendungsschaltung.

7. Testsystem nach einem der vorherigen Ansprüche, bei dem die physikalische Größe eine Ausbreitungszeit ist und die Messprüfvorrichtung (MES) zum Messen einer Ausbreitungszeit eines Signals zwischen zwei Speicherlogikzellen ausgelegt ist.

8. Testsystem nach einem der Ansprüche 1 bis 6, bei dem die physikalische Größe ein verbrauchter Strom ist und die integrierte Charakterisierungsschaltung (CAR) ferner für jede Teststruktur (ST1, ST2) eine Vorrichtung (DMC) zum Messen des verbrauchten Stroms in der Teststruktur umfasst, die mit der Messprüfvorrichtung (MES) zusammenwirken kann.

9. Verfahren zum Testen einer integrierten Anwendungsschaltung, dargestellt durch eine Beschreibung, die einen Satz von Pfaden umfasst, die mehrere Logikzellen verbinden, wobei das Verfahren von einem Testsystem (SYS) durchgeführt wird, das eine integrierte Charakterisierungsschaltung (CAR), die mindestens zwei konfigurierbare Teststrukturen (ST1, ST2) umfasst, jeweils mit mehreren aktivierbaren Logikzellen und mehreren Verbindern zum Aktivieren und Verbinden der Logikzellen, und einen Testsatz (EDT) umfasst, wobei das Verfahren die folgenden Schritte beinhaltet:

- Variieren (601) mindestens eines physikalischen Parameters mindestens einer konfigurierbaren Teststruktur zum Beschleunigen ihrer Alterung, um mindestens eine degradierte Teststruktur zu erhalten,

- Empfangen (602) einer Beschreibung einer integrierten Anwendungsschaltung und Extrahieren mindestens eines Pfades aus der Beschreibung,

- Aktivieren und Verbinden (603) mindestens eines Teilsatzes der Logikzellen mindestens einer degradierten Teststruktur und mindestens einer nicht degradierten Teststruktur, um jeweils eine Topologie identisch mit mindestens einem Teil eines extrahierten Pfades zu realisieren,

- Durchführen (604) mindestens einer ersten Messung einer physikalischen Größe an der mindestens einen degradierten Teststruktur und mindestens einer mit der ersten Messung identischen zweiten Messung an der mindestens einen nicht degradierten Teststruktur.

10. Verfahren zum Testen einer integrierten Anwendungsschaltung nach Anspruch 9, bei dem der Teil des aus der Beschreibung der integrierten Anwendungsschaltung extrahierten Pfades mindestens drei in Serie geschaltete Logikzellen umfasst.

11. Verfahren zum Testen einer integrierten Anwendungsschaltung nach Anspruch 10, bei dem der Teilsatz von aktivierten und verbundenen Logikzellen ferner Folgendes umfasst:

- eine zusätzliche Speicherlogikzelle, die oberhalb der drei extrahierten Logikzellen angeschlossen wird, wenn die erste Logikzelle des Teils des extrahierten Pfades keine Speicherlogikzelle ist,
- eine zusätzliche Speicherlogikzelle, die unterhalb der drei extrahierten Logikzellen angeschlossen wird, wenn die letzte Logikzelle des Teils des extrahierten Pfades keine Speicherlogikzelle ist.

12. Verfahren zum Testen einer integrierten Anwendungsschaltung nach Anspruch 10 oder 11, bei dem die Messung von mindestens einer physikalischen Größe mindestens an einer Speicherlogikzelle des Teilsatzes erfolgt.

13. Verfahren zum Testen einer integrierten Anwendungsschaltung nach Anspruch 12, wobei das Verfahren wiederholt wird, indem der Teil des extrahierten Pfades gemäß einem Gleitfenster zum Durchlaufen des gesamten Pfades variiert wird.

14. Verfahren zum Testen einer integrierten Anwendungsschaltung nach einem der Ansprüche 9 bis 13, bei dem der physikalische Parameter aus einer Temperatur der Schaltung, einer Speisespannung, einem am Eingang der Schaltung injizierten Stimulus variabler Art und Dauer ausgewählt wird.

15. Verfahren zum Testen einer integrierten Anwendungsschaltung nach einem der Ansprüche 9 bis 14, das ferner eine Schätzung (605) einer zeitlichen Variation mindestens einer physikalischen Größe der integrierten Anwendungsschaltung auf der Basis von Messungen beinhaltet, die an der mindestens einen degradierten Teststruktur und an der mindestens einen nicht degradierten Teststruktur durchgeführt werden.

16. Verfahren zum Testen einer integrierten Anwendungsschaltung nach Anspruch 15, bei dem das Schätzen (605) das Berechnen der Differenz zwischen zwei an der mindestens einen degradierten Teststruktur und an der mindestens einen nicht degradierten Teststruktur durchgeführten identischen Messungen beinhaltet.

17. Verfahren zum Testen einer integrierten Anwendungsschaltung nach Anspruch 16, wobei das Schätzen (605) das Berechnen eines Verhältnisses zwischen einer Summe von Differenzen zwischen zwei an der mindestens einen degradierten Teststruktur und an der mindestens einen nicht degradierten Teststruktur durchgeführten identischen Messungen und einer Summe von an der mindestens einen nicht degradierten Teststruktur durchgeführten Messungen beinhaltet.

18. Verfahren zum Testen einer integrierten Anwendungsschaltung nach Anspruch 17, bei dem die physikalische Größe eine Ausbreitungszeit oder ein verbrauchter Strom ist.

**Claims**

1. System (SYS) for testing an application-specific integrated circuit represented by a description comprising a assembly of paths linking several logic cells, the test system (SYS) comprising a characterization integrated circuit (CAR) comprising at least two configurable test structures (ST1, ST2), each comprising a plurality of activatable logic cells (A, B, C, R1, R2) and a plurality of connectors for activating and interconnecting the logic cells, and a test assembly (EDT) comprising:

- a device (CTR) for controlling the integrated characterization circuit, configured to vary at least one physical parameter of at least one test structure configurable to accelerate its aging so as to obtain at least one degraded test structure,
- an interface (INT) for receiving at least one description of an application-specific integrated circuit and extracting at least one path from the description,
- a device (CONF) for configuring the integrated characterization circuit to activate and interconnect at least one subset of logical cells of at least one degraded test structure and at least one non-degraded test structure, so that they each produce a topology identical to at least one portion of an extracted path,
- a measurement control device (MES) for performing at least one first measurement of a physical quantity on said at least one degraded test structure and at least a second measurement, identical to the first measurement, on said at least one non-degraded test structure.

2. The test system according to claim 1, wherein each test structure (ST) comprises combinatorial logic cells (A, B, C) and memory logic cells (R1, R2).

3. The test system as claimed in one of the preceding claims, wherein the device (CTR) for controlling the integrated characterization circuit comprises a device (CTEMP) for controlling the temperature of at least one test structure.

4. The test system as claimed in one of the preceding claims, wherein the device (CTR) for controlling the integrated characterization circuit comprises a generator (GSTIM) of stimuli that are intended to be injected at an input point of at least one test structure.

5. The test system as claimed in one of the preceding claims, wherein the device (CTR) for controlling the integrated characterization circuit comprises a device (CTENS) for controlling the supply voltage of at least one test structure.

6. The test system as claimed in one of the preceding claims, wherein the system further comprises an estimation device (EST) configured to determine, from the measurements supplied by the measurement device, an estimation of a variation over time of at least one physical quantity of the application-specific integrated circuit.

7. The test system as claimed in one of the preceding claims, wherein the physical quantity is a propagation time and the measurement control device (MES) is able to measure a propagation time of a signal between two memory logical cells.

8. Test system as claimed in one of claims 1 to 6 wherein the physical quantity is a current that is consumed and the characterization integrated circuit (CAR) furthermore comprises, for each test structure (ST1, ST2), a device (DMC) for measuring the current consumed in the test structure that is able to interact with the measurement control device (MES).

9. A method for testing an application-specific integrated circuit represented by a description comprising a set of paths linking a plurality of logic cells, the method being implemented by way of a test system (SYS) comprising an integrated characterization circuit (CAR) comprising at least two configurable test structures (ST1, ST2), each comprising a plurality of activatable logic cells and a plurality of connectors for activating and interconnecting the logic cells and a test assembly (EDT), the method comprising the steps of:

- varying (601) at least one physical parameter of at least one configurable test structure so as to accelerate its aging so as to obtain at least a degraded test structure,
- receiving (602) a description of an application-specific integrated circuit and extracting at least one path from the description,
- activating and interconnecting (603) at least a subset of logic cells of at least one degraded test structure and of at least one non-degraded test structure, so that each produces a topology identical to at least one part of an extracted path,
- performing (604) at least one first measurement of a physical quantity on said at least one degraded test structure and at least one second measurement, identical to the first measurement, on said at least one non-degraded test structure.

10. The method for testing an application-specific integrated circuit as claimed in claim 9, wherein the portion of the path extracted from the description of the integrated application circuit comprises at least three logic cells connected in series.

11. The method for testing an application-specific integrated circuit as claimed as in claim 10, wherein said subset of activated and interconnected logic cells furthermore comprises:

- an additional memory logical cell connected upstream of the three extracted logical cells if the first logical cell of the portion of the extracted path is not a memory logical cell,
- an additional logical memorization cell connected downstream of the three extracted logical cells if the last logical cell of the portion of the extracted path is not a memorization logical cell.

12. The method for testing an application-specific integrated circuit as claimed as in either of claims 10 or 11 wherein the measurement of at least one physical quantity is carried out at least on a memory logic cell of said subset.

13. The method for testing an application-specific integrated circuit as claimed as in claim 12, wherein the method is iterated by varying the portion of the extracted path using a sliding window to cover the entire path.

14. The method for testing an application-specific integrated circuit as claimed as in one of claims 9 to 13 wherein said physical parameter is selected among a temperature of the circuit, a supply voltage, a stimulus injected at the input of the circuit of the variable nature and duration.

15. The method for testing an application-specific integrated circuit as claimed as in one of claims 9 to 14, furthermore comprising estimating (605) a variation over time of at least one physical quantity of the application-specific integrated circuit from the measurements performed on said at least one degraded test structure and on said at least one non-degraded test structure.

16. The method for testing an application-specific integrated circuit as claimed as in claim 15, wherein the estimation (605) comprises calculating the difference between two identical measurements performed on said at least one degraded test structure and on said at least non-degraded test structure.

17. The method for testing an application-specific integrated circuit as claimed as in claim 16 wherein the estimation (605) comprises calculating a ratio between a sum of the differences between two identical measurements performed on said at least one degraded test structure and on said at least one non-degraded test structure and a sum of the measurements performed on said at least one non-degraded test structure.

18. The method for testing an application-specific integrated circuit as claimed as in claim 17, wherein the physical quantity is a propagation time or a current that is consumed.

FIG.1

EP 3 443 369 B1

FIG.2

FIG.3

FIG.4

FIG.5

```
┌──────────────────┐                    ┌──────────────────────┐
╱ Profils de       ╱ ─────────────────▶ │  Vieillissement d'une │
╱ mission du CI    ╱                    │  structure de test    │
└──────────────────┘                    └──────────────────────┘
                          601                       │
                                                    ▼
┌──────────────────┐                    ┌──────────────────────┐
╱ Description      ╱ ─────────────────▶ │  Extraction cellules  │◀──┐
╱ CI              ╱                     └──────────────────────┘    │
└──────────────────┘        602                     │              │
                                                    ▼              │
                                        ┌──────────────────────┐    │
                                        │ Configuration structure de │
                                        │ test vieillie et structure de │
                                        │      test saine       │    │
                                   603  └──────────────────────┘    │
                                                    │              │
                                                    ▼              │
                                        ┌──────────────────────┐    │
                                        │       Mesures         │    │
                                   604  └──────────────────────┘    │
                                                    │──────────────┘
                                                    ▼
                                        ┌──────────────────────┐
                                        │      Estimation       │
                                   605  └──────────────────────┘
```

# FIG.6

FIG.7

FIG.8

FIG.9

**EP 3 443 369 B1**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20120245879 A1
- US 2009027990 A